# EUROPEAN PATENT APPLICATION

(11) **EP 1 508 926 A1**
(43) Date of publication of application: **23.02.2005**
(21) Application number: 03255119.4
(22) Date of filing: 19.08.2003
(51) Int. Cl.: H01L 51/30

(54) **Nanotube transistor device**

(71) Applicant: Hitachi, Ltd., Chiyoda-ku, Tokyo 101-8010 (JP)
(72) Inventor: Kim, Byong Man, Cambridge CB4 1JD (GB); Nakazato, Kazuo, Cambridge CB2 2RP (GB); Mizuta, Hiroshi, Great Shelford, Cambridge CB2 5JW (GB)
(74) Representative: Read, Matthew Charles

(57) **Abstract**

A transistor device comprising source and drain regions (S, D), a nanotube structure (2, 3) providing a path for electrical charge carriers between the source and drain regions, and a gate region (4). The nanotube structure has its conduction band structure locally modified in the gate region, e.g. by doping, for controlling the passage of the charge carriers in the path. The device can be used as a flash memory or as a memory element in a DRAM.

## Description

This invention relates to a transistor device employing a nanotube.

Nanotubes comprise nanometer scale tubular structures, typically made from a sheet of carbon atoms known as a graphene. They may be single wall or multi-wall structures. A single-walled carbon nanotube typically comprises an elongated, single hollow tube that is about 1 nm in diameter and few-hundredsnm to few-hundreds-µm in length. A multi-walled carbon nanotube consists of a plurality of generally concentric, hollow tubes of different diameters that can range up to a few hundreds of nanometers. One popular method of synthesizing high quality carbon-nanotube structures uses a chemical vapour deposition technique based on a vapour-solid interaction of methane and hydrogen with a catalyst in a heated environment, as described by J. Kong, H. T. Soh, A. Cassell, C. F. Quate, H. Dai, Nature, 395, 878 (1998). A carbon-nanotube structure can act as a semiconductor or a metal, depending on its diameter and how it is rolled up from a sheet of graphene, and has been demonstrated to be harder than the steel and a better conductor than copper. Reference is directed to P. McEuen, M. Fuhrer, H. Park, IEEE Transactions on Nanotechnology, 1, 78 (2002).

Various devices have been formed from carbon-nanotube structures. Ballistic conduction in nanotube structures has been reported where nanotubes placed between ferromagnetic contacts were used to demonstrate coherent transport of electron spin, as described by K. Tsukagoshi, B. Alphenaar and H. Ago, Nature, 401, 572 (1999).

There have been a number of reports on the use of nanotube structures as the channel material of transistors which performed better than state of the art CMOS or SOI prototypes and reference is directed to S. Tans, A. Verschueren, and C. Dekker, Nature, 393, 49 (1998); R. Martel et al., Appl. Phys. Lett., 73, 2447 (1998); and A. Javey et al., Nature Materials, published online: 17 Nov. 2002; doi:10.1038/nmat769. Logic functions have also been demonstrated from assembly of nanotube transistors, as described in V. Derycke, Nano Letters, 1, 453 (2001) and A. Bachtold et al., Science, 294, 1317 (2001).

A single electron memory was demonstrated in which a nanotube channel of a transistor was used as a single electron sensor and manipulator - see M. Fuhrer et al., Nano Letters, 2, 755 (2002). Also, a nanotube channel of a transistor has been used as an IR source, in which the IR emission was achieved by recombining electrons and holes in the nanotube channel, injected from the source and drain of the transistor, as reported by J. A. Misewich et al., Science 300, 783 (2003).

The structures described so far are demonstration devices and not apt to yield consistent device characteristics. Various methods of forming heterojunctions in carbon-nanotube structures have been proposed in an attempt to produce more reliable devices. Heterojunctions formed by adjoining carbon-nanotubes of differently rolled-up layers of closely packed carbon atoms of different diameters have been proposed in US Patent No 6,538,262 to V. Crespi et al.. Structures utilising mechanical deformation i.e., by straining or bending are described in US Patent Application 20020027312 A1, Mar. 7, 2002. Chemical doping of carbon-nanotube structures has been proposed by C. Zhou, Science, 290, 1552 (2000) to B. Yakobson. Also, a method of forming a heterojuntion in a nanotube structure by means of a heat induced solid-solid diffusion and chemical reaction is described in US-A-6,203,864 to Y. Zhang and S. Iijima.. However, these junction forming techniques are not particularly suited to forming transistor structures.

US Patent Application 20030044608 A1 by H. Yoshizawa discloses a number of nanotube structures in which an outer graphene sheet is chemically modified to change its conductive characteristics, but the resulting structure does not exhibit a transistor action.

It has been proposed to use Y-shaped nanotube structures to form transistors as described in US Patent 6,325,909 to J. Li et al.. The transistor action results from heterojunctions formed by structural defects in the vicinity of the confluence of the arms of the Y-shaped nanotube and so the device lacks reproducibility. Also, transistors comprising vertically extending nanotube structures have been proposed in US Patent 6,515,325 to W. Farnworth, and US Patent 6,566,704 to W. Choi et al. However, vertical nanotube structures are known to include a high density of various defects and exhibit poor semiconductor properties, degrading performance of the transistor.

The present invention seeks to provide an improved, reproducible transistor device that uses a nanotube for its conductive channel.

According to the invention there is provided a transistor device comprising source and drain regions, a nanotube structure providing a path for electrical charge carriers between the source and drain regions, and a gate region, the nanotube having its conduction band structure locally modified in the gate region for controlling the passage of the charge carriers in the path.

The gate region may comprise a locally doped region of the nanotube structure.

The nanotube structure may comprise first and second and more generally n nanotubes one within the other and the locally doped region may extend into one or some of the nanotubes but not the or each of the others. Alternatively the locally doped region may extend into both or all of the nanotubes.

The doped region may comprise a semiconductor providing a conduction band barrier that can be controlled by an external voltage applied to the gate region, to control conduction along the path between the source and drain.

The doped region may also comprise a conductor that forms a Schotkky junction in the nanotube structure that can be controlled by an external voltage applied to the gate region to control conduction along the path between the source and drain.

The gate region may act as a region for electrons and holes to combine and emit photons. The device may also be operable as a flash memory.

The nanotube structure may be formed of carbon and the gate may include a carbide-containing region in the nanotube structure such as silicon carbide or a metallic carbide.

Arrays of the transistors may be formed on a common nanotube structure to be used for example as a flash memory.

The invention also includes a method of fabricating a transistor comprising providing source and drain regions, providing a nanotube structure between the source and drain regions, and modifying the conduction band structure of the nanotube structure locally in a gate region for controlling the passage of the charge carriers through the nanotube structure between the source and drain, and providing a gate connection to the gate region.

In order that the invention may be more fully understood embodiments thereof will now be described with reference to the accompanying drawings in which:
Figure 1 is an enlarged schematic perspective view of a conventional nanotube structure that contains two nanotubes by way of example;
Figure 2 is a view corresponding to Figure 1, of a nanotube structure for a transistor device according to the invention having its conduction band structure locally modified to form a barrier in a gate region;
Figure 3 is a longitudinal section taken along S-D in Figure 2 for a first type of transistor (type A) according to the invention;
Figure 4 is a transverse section along the line A-A' of Figure 3;
Figure 5 is a longitudinal section taken along S-D in Figure 2 for a second type of transistor (type B) according to the invention;
Figure 6 is a transverse section along the line B-B' of Figure 5;
Figure 7 is an enlarged schematic illustration of the nanotube structure of Figure 3 (type A) for illustrating band gaps across the barrier ;
Figures 8A and 8B are band gap diagrams longitudinally across the barrier in direction x shown in Figure 7 for rectangular and Schottky doping respectively;
Figures 9A and 9B are band gap diagrams in a radial direction y across the nanotube structure in the barrier shown in Figure 7, for rectangular and Schottky doping respectively;
Figure 10 is an enlarged schematic illustration of the nanotube structure of Figure 5 (type B) for illustrating band gaps across the barrier ;
Figures 11A and 11B are band gap diagrams longitudinally in direction x across the barrier layer shown in Figure 10 for rectangular and Schottky doping respectively;
Figure 12 is a schematic perspective illustration of a transistor (type A) in accordance with the invention;
Figure 13 is a longitudinal sectional view taken in the direction S-D of Figure 12;
Figure 14 is a transverse section of the transistor of Figure 13 taken along the line A-A';
Figure 15A is a band diagram of the transistor of Figures 12-14 for a rectangular doped gate region, with no applied gate bias, in the off state;
Figure 15B is a band diagram of the transistor of Figures 12-14 for a rectangular doped gate region, with an applied gate bias, in the on state;
Figure 16A is a band diagram of the transistor of Figures 12-14 with a Schottky junction gate region, with no applied gate bias, in the off state;
Figure 16B is a band diagram of the transistor of Figures 12-14 with a Schottky junction gate region, with an applied gate bias, in the on state;
Figure 17 is a graph of the gate voltage/source-drain current transfer characteristic of the device of Figures 12-14;
Figures 18A and 18B are radial band diagrams corresponding to Figure 9A illustrating how the transistor can operate as a flash memory;
Figure 19 is a graph of the gate voltage/source-drain current transfer characteristic of the transistor operable as a flash memory;
Figure 20 is a schematic perspective illustration of a transistor (type B) in accordance with the invention;
Figure 21 is a longitudinal sectional view taken in the direction S-D of Figure 20;
Figure 22 is a transverse section of the transistor of Figure 21 taken along the line B-B';
Figure 23 is a graph of the gate voltage/source-drain current transfer characteristic of the device of Figures 20-22;
Figures 24A and 24B are band diagrams of the transistor of Figure 20 in the off and on states respectively;
Figures 25A and 25B are band diagrams of the transistor of Figure 20 in the off and on states respectively for generating photons;
Figures 26A-F illustrate process steps in the fabrication of transistors according to type A and type B;
Figures 27A-F illustrate alternative doped nanotube structures for use in transistors according to the invention;
Figure 28 is a schematic cross sectional view of a row of a flash memory cell array that uses type A transistors according to the invention;
Figure 29 is a schematic cross sectional view of a row of a flash memory cell array that uses type B transistors according to the invention; and
Figure 30 is a schematic circuit diagram of the flash memory cell array shown in Figures 28 or 29.

### Overview

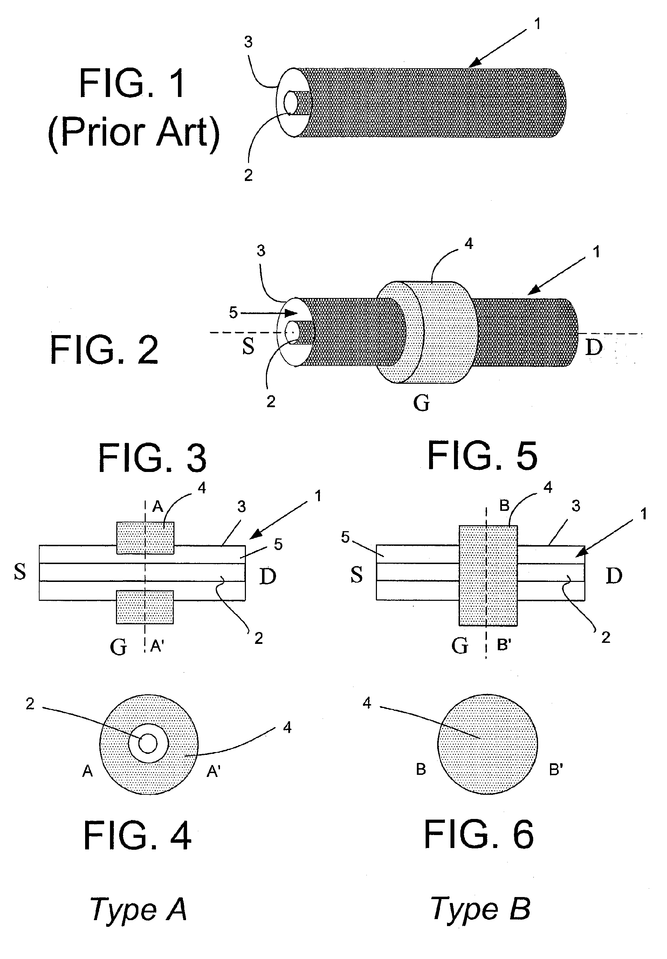

Figure 1 illustrates a conventional nanotube structure formed according to any one of the previously described known methods. In this example, nanotube structure 1 comprises first and second generally concentric nanotubes 2, 3 fabricated e.g. from a graphene sheet. The diameters of the tubes 2, 3 are on a nanometer scale, as previously described. In this example, two nanotubes are shown although in practice, the nanotube structure 1 may include only one or many such nanotubes, one within the other.

Figure 2 illustrates how such a nanotube structure can be modified so as to form the basis of a transistor in accordance with the invention. The energy bandgap and/or the band profile of the nanotube structure 1 is modified locally in region 4 so as to modify the electrical properties of the nanotube structure 1. The resulting structure provides a channel between source and drain regions S, D and the characteristics of the modified region are controlled by a gate G, to be described in more detail hereinafter.

The region 4 formed in the nanotube structure 1 is preferably formed of a nonconducting and/or wide bandgap and/or lattice-mismatching material. However, the region 4 may be formed of any material provided that the energy band profile or the bandgap of the nanotube structure 1 is modified so as to introduce at least one electrostatic barrier or well, so that the conduction cross-section and/or the conduction path or, more generally, an electrical property of the nanotube structure is modified. The energy band profile or bandgap of the structure in region 4 is achieved by engineering the material content and geometry of the region formed in the nanotube structure 1.

In the following example, the region 4 is formed by doping the nanotube structure 1 and the doping can be carried out through one or both of the nanotubes 2, 3 selectively to achieve different types of core structure referred to hereinafter as type A and type B. An example of type A is shown in Figures 3 and 4 and a corresponding example of type B is illustrated in Figures 5 and 6. In the described example, only two nanotubes 2, 3 are shown with a radial space 5 between them, although it will be understood that the principles described herein can be extended to larger numbers of nanotubes one within the other, as will be explained in more detail later.

Referring to the type A core structures shown in Figure 3 and 4, the doped region 4 extends through the outermost nanotube 3 but not through the innermost nanotube 2. In contrast, in type B, the region 4 extends through both of the nanotubes 2, 3 which can be seen from the type B structure shown in Figures 5 and 6. Thus, in type A, a conductive path is always provided between source and drain regions S, D along the nanotube 2 whereas in type B, charge carriers need to pass through the region 4 in order to travel between the source and drain regions S, D. The region 4 may formed of a relatively wide bandgap material such as a relatively wide bandgap semiconductor material e.g. silicon carbide, in which case electrostatic potential barriers are introduced at the interfaces between the nanotube and the region 4. Alternatively, the region 4 may be formed of a metal carbide such as NbC so that electrostatic potential barriers of the Schottky type are introduced at the interfaces with the or each of the nanotubes.

### Potential Barriers - Type A

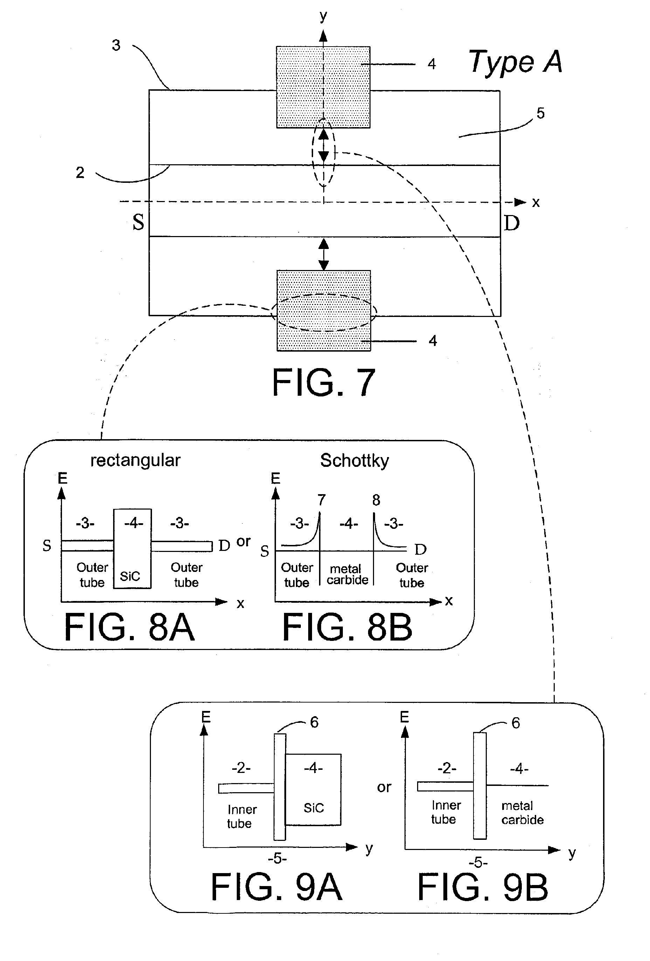

Referring to Figures 7, 8 and 9 the potential barriers in the nanotube structure 1 are illustrated for a type A core structure. The doped region 4 extends into the outermost nanotube 3 but not into the inner nanotube 2. When the region 4 comprises silicon carbide, the bandgap of the material of the outer nanotube 3 is modified along its length (in the x direction) as shown in Figure 8A to provide a potential barrier both in the valence and conduction bands. Figure 9A illustrates the corresponding bandgap for the SiC region 4 in the radial direction y of the nanotube structure. The space 5 between the inner and outer nanotubes 2, 3 gives rise to a barrier 6 between the relatively wide bandgap associated with the silicon carbide region 4 and the relatively narrow bandgap associated with the conductive inner nanotube 2.

Figures 8B and 9B illustrate corresponding situations for a metal carbide region 4 producing Schottky barriers. As shown in Figure 8B, Schottky barriers 7, 8 occur at the boundaries of the metal carbide region 4 in the outer nanotube 3. The space 5 between the nanotubes 2, 3 gives rise to a potential barrier 6 between the bandgap of the inner tube 2 and the metal carbide region 4, as shown in Figure 9B.

### Potential Barriers - Type B

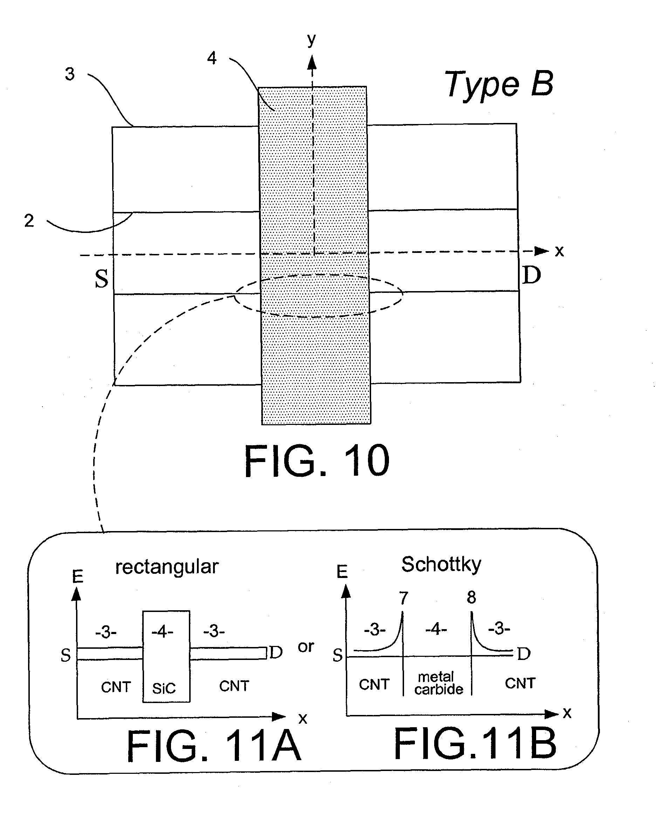

Figures 10 and 11 correspond to Figures 7 and 8 for the type B core structure 1. As previously explained, the region 4 extends through both of the nanotubes 2, 3 and, as illustrated in Figure 11A and 11B, the bandgap in the inner nanotube 2 corresponds to the bandgap in the outer nanotube 3, previously described with reference to Figures 8A and 8B. Thus, normally, charge transfer between the source and drain regions S, D is not allowed and no current flows. However, in accordance with the invention, the energy band profile of the region 4 can be modified by external means such as the application of the gate voltage to allow charge carrier flow between the source and drain regions, as will be described in more detail later.

### Transistor Device Structure - Type A

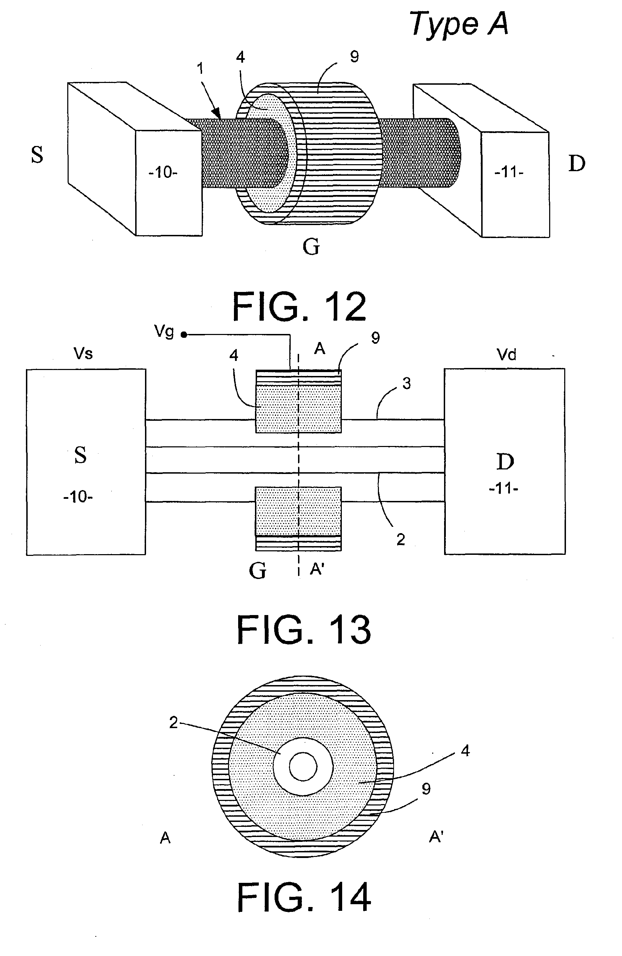

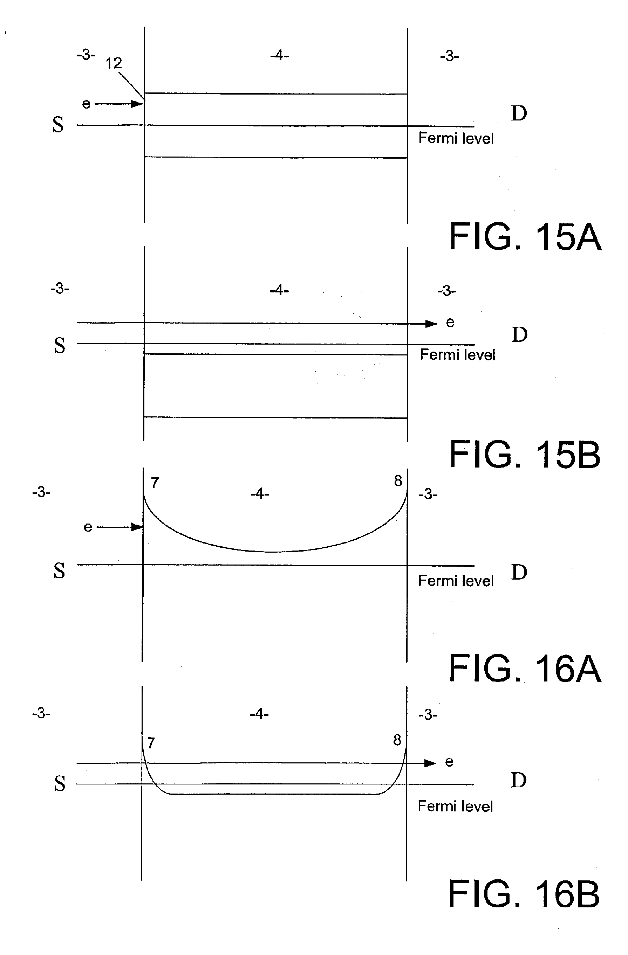

Figures 12, 13 and 14 illustrate schematically an example of a transistor device incorporating the type A core structure previously described. The nanotube structure 1 with modified band structure region 4 is provided with a gate electrode 9, together with source and drain regions 10, 11. The electrode 9 may be formed any suitable conductive material such as n-doped silicon as described in more detail later. The regions 10, 11 may comprise Au or other suitable conductive contacts. The device may be formed on an insulating later of silicon dioxide on a silicon substrate (not shown) to be described in more detail later. As previously described, the modified region 4 extends through the outermost carbon nanotube 3 but not into the innermost nanotube 2. A gate voltage Vg can be applied to gate electrode 9. Figure 15A illustrates a band diagram of the device across the modified region 4 when no gate voltage Vg is applied, in the region of the outer nanotube 3. In this situation, the relatively wide bandgap of the material 4 gives rise to a barrier 12 at the interface with the nanotube 3, which inhibits passage of conduction electrons e between the source and drain regions 10, 11. However, when gate voltage Vg is applied, the barrier presented by the bandgap of material is shifted downwardly allowing the passage of electron e along the nanotube 3, through the region 4 between the source and drain regions 10, 11.

Figures 16A and 16B illustrate operation of the device when the region 4 comprises a metallic carbide. Schottky barriers 7, 8 inhibit the passage of electron e from source region 10 to drain region 11 through the doped region 4, in the absence of an applied gate voltage Vg. However, when the gate voltage V_{g} is applied to the region 4, the junction barriers 7, 8 are shifted downwardly allowing passage of the electron e from the source region to the drain region 11 through the outer nanotube 3.

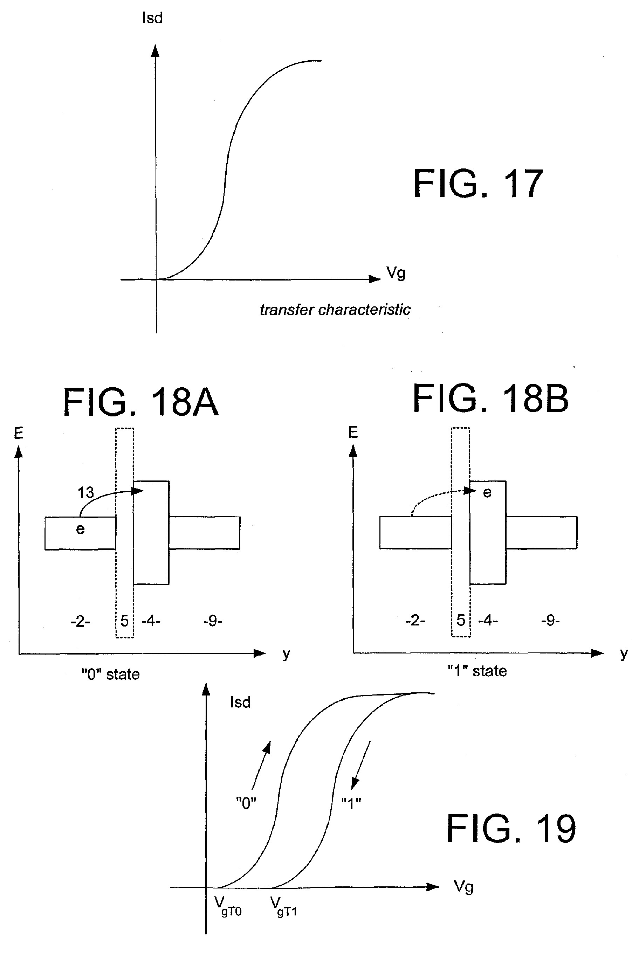

Figure 17 is a graph of the transfer characteristic of the device, in which the source/drain current I_{sg} is plotted as a function of gate voltage Vg, for a constant source/drain voltage V_{sd}. It will be understood that the shape of the graph corresponds to a classic transistor transfer characteristic.

### Flash Memory

Referring to the energy band diagrams of Figures 18A and 18B, the device can be used as a flash memory by causing electrons to be stored in imperfections in the modified region 4. Referring to Figure 18A, electrons e can be caused to tunnel through the barrier 6 so as to become stored in the modified region 4 when a suitable write gate voltage V_{gw} is applied to the gate 9. In a so-called "0" state, no excess electrons are stored in the region 4. However, by the application of the write gate voltage V_{gw}, electron e can be caused to tunnel from the source/drain path provided by nanotube 2, as shown by arrow 13 into the modified region 4 so as to produce a "1" state as shown in Figure 18B. The device can be switched back into the "0" state by applying an inverse bias across the region 4 to cause the stored electrons to return to the source/drain path. The modified region 4 may provide charge storage sites as a result of its structural inhomogeneity and/or at its interfaces with the nanotube 3. The device therefore can operate as a flash memory in which the memory operation is characterised by hysteresis in the transfer characteristic of the device, as illustrated in Figure 19. From the graph, it can be seen that the source /drain current of the transistor is switched on at different threshold voltages V_{gT0} and V_{gT1} depending on whether the transistor is in a "0" or a "1" state and this can be used to store and read data from the transistor, as explained in more detail hereinafter.

### Transistor Structure - Type B

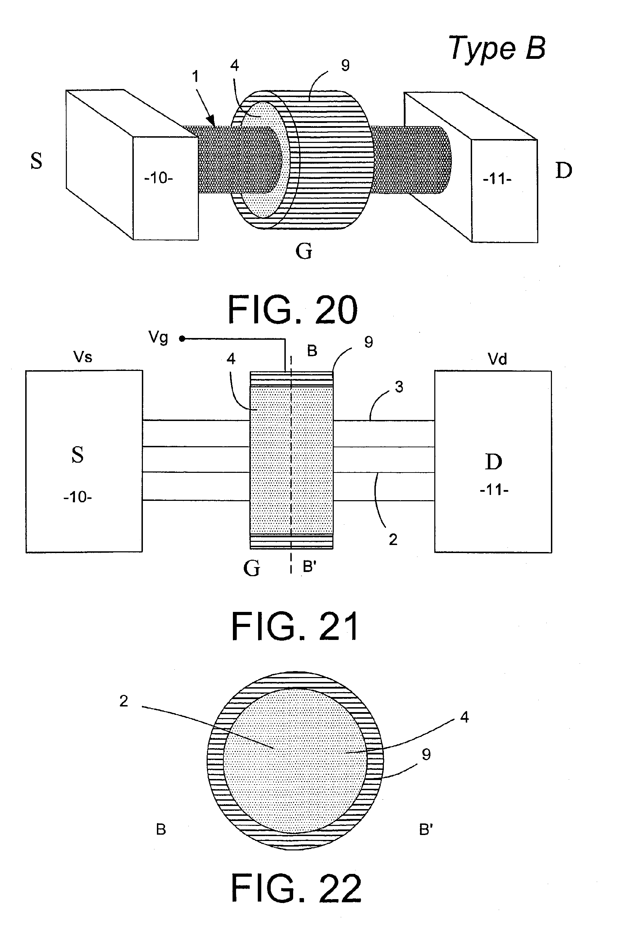

Figures 20, 21 and 22 illustrate a transistor that uses a previously described type B core structure. The nanotube structure 1 with associated modified region 4 is provided with a conductive silicon gate region 9 together with source and drain regions 10, 11 which may be metallic as previously described. The device may be formed on an insulating later of silicon dioxide on a silicon substrate (not shown) to be described in more detail later. As previously explained, the modified region 4 extends through both of the inner and outer nanotubes 2, 3. The device gives rise to a transistor-like transfer characteristic as shown in Figure 3 in solid outline, in which the source drain current I_{sg} is plotted as a function of gate voltage V_{g} for constant V_{sd}.

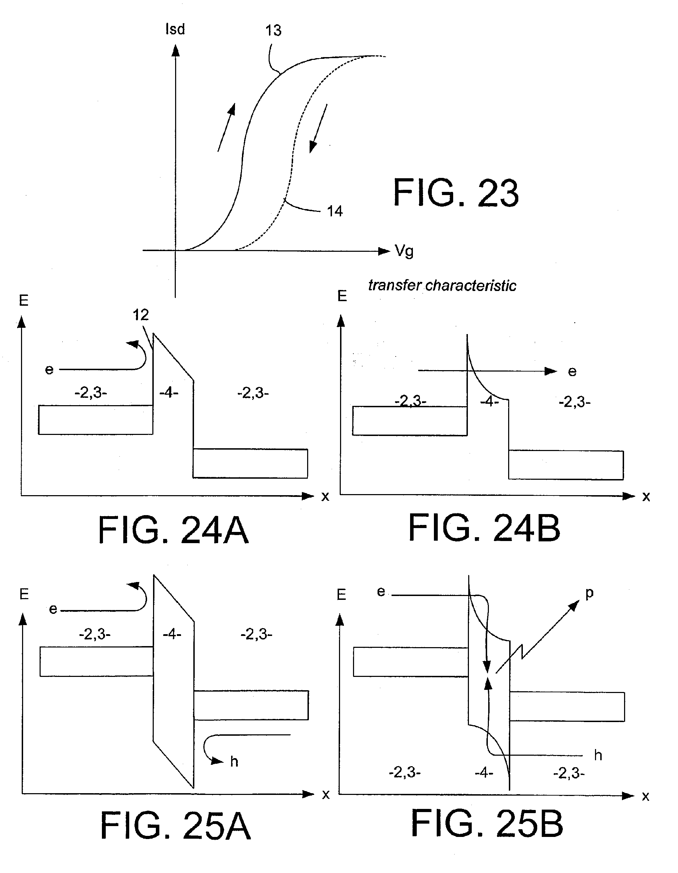

Referring to Figure 24A, when the modified region 4 is made of silicon carbide, in the absence of an applied gate voltage Vg, electron e is unable to tunnel through the barrier 11 presented by the modified region 4. However, when a gate voltage Vg is applied, the barrier presented by the region 4 is modified so as to become much narrower, allowing electrons to pass from the source region 10 to drain region 11 through both of the nanotubes 2, 3. If the modified region 4 contains charge storage sites, the device may exhibit hysteresis and be operable as a flash memory device in the manner previously described for the type A transistor. For example, when the region 4 is made of silicon carbide, it may include structural inhomogeneities which allow charges to become stored therein. The charges may be written into and removed from the material 4 by the application of a suitable gate voltage V_{gw}. As a result, charges can be written to and erased from the region 4 and the transistor device exhibits hysteresis as illustrated by dotted line 14 in Figure 23.

### Photon Source

Referring to Figures 25A and B, the device shown in Figures 20 - 22 can also be used as a photon source in which electrons e and holes h combine to produce photons p in the region 4. As shown in Figure 25A, when no gate voltage V_{g} is applied, the material of region 4 acts as a barrier and no conduction occurs. However, when a gate bias is applied as shown in Figure 25B, the barrier structure presented by the material 4 is modified so that electrons and holes can enter region 4 and combine to produce photons. In Figure 25B, electron e and hole h enter the region 4 and combine to produce photon p. The intensity of the light produced can be controlled by altering the gate bias V_{g} so as to change the barrier and hence the rate at which electrons and holes enter the material 4 to combine therein.

The device can be designed to emit photons of particular wavelengths by appropriately tailoring the energy band profile of the nanotube structure 1, by engineering the material content of the material 4.

### Fabrication Method

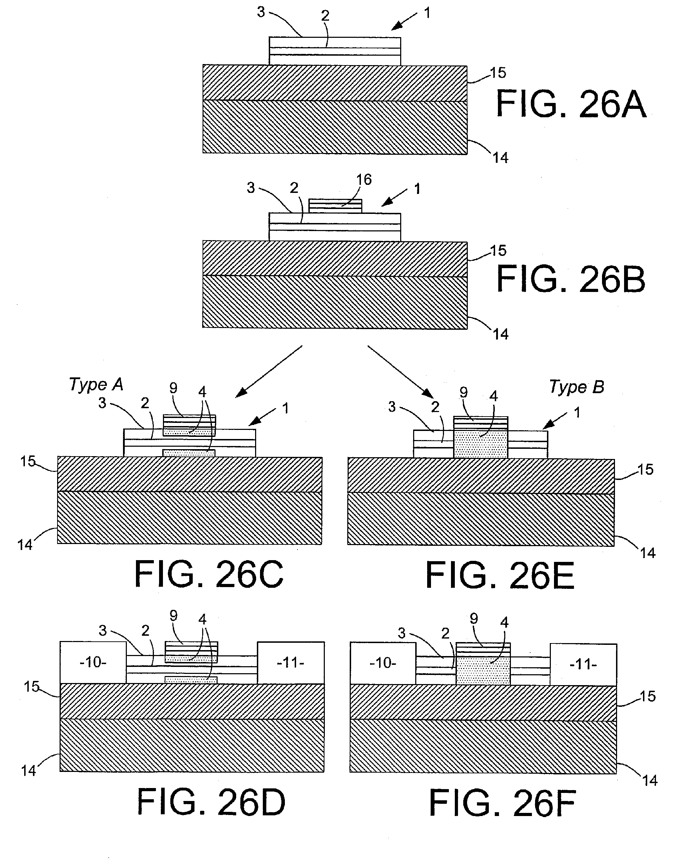

Referring to Figure 26, a transistor according to the invention can be fabricated by placing the nanotube structure 1 on a silicon substrate 14 covered by an insulating layer of silicon dioxide with a typical thickness of 100nm, although a thickness down to one or two nanometres could be used. The length of the nanotube structure 1 is typically of the order of 2µm. The resulting arrangement is shown in Figure 26A.

Then as shown in Figure 26B, a doped region of silicon 16 is formed so as to cover surround or quasi-surround a section of the nanotube structure 1. The region 16 can be deposited by conventional masking and deposition techniques as will be evident to those skilled in the art. Region 16 may comprise doped or undoped silicon, as long as it is conductive to act as a gate. Gallium or arsenic can be used as a dopant. A typical thickness for region 16 is 30nm. The region 16 is used to produce the modified region 4 and the surrounding gate electrode 9 by heating the device in a furnace. Different process conditions are used to produce a type A or type B device.

The process steps for a type A device are shown in Figures 26C and D. Referring to Figure 26C, the sample is heated in a furnace to a sufficiently elevated temperature to induce a solid-solid diffusion and a chemical reaction between atoms in the doped silicon 16 and the nanotube structure 1 to convert a section of the outer nanotube 3 into silicon carbide 4 surrounding a portion of the inner tube 2. The silicon carbide forming process is optimised such that some of the doped silicon does not participate in the forming process so as to provide the gate electrode 9 overlying the region 4. The partial SiC conversion can be achieved by heating the sample in a vacuum or in argon, at a temperature e.g. of 800°C for 5 minutes.

Then, as shown in Figure 26D, source and drain contacts 10, 11 are formed to make electrical connections with the nanotube structure 1. The source and drain contacts 10, 11 may be formed of gold or gold with a titanium or niobium adhesion layer in a manner well known *per se* in the art.

Corresponding steps for a type B device as shown in Figure 26E and F and the process steps are similar to those of Figure 26C and D although the period of heating in the furnace is extended for sufficient time to convert portions of both the inner and outer nanotubes 2, 3 into silicon carbide as shown in Figure 26E. The full SiC conversion can be achieved by heating the sample in a vacuum or in argon at a temperature of e.g. 800°C for 20 minutes.

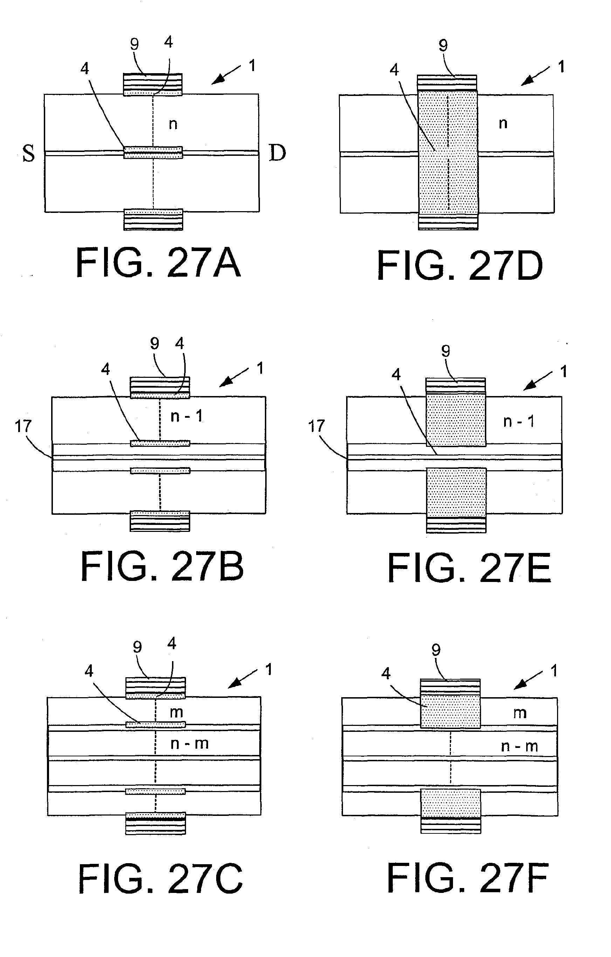

In the examples given so far, the nanotube structure comprises two generally concentric nanotubes 2, 3. Figure 27 illustrates a number of longitudinal cross sections of different configurations of the region 4 in the nanotube structure 1, where the structure contains n nanotubes one within the other.

In the examples of Figures 27A, B and C, the material 4 is formed around certain of the nanotubes individually. In Figure 27A, the region 4 bounds each of the n nanotubes individually. In Figure 27B, the region 4 bounds each of the *n* nanotubes except for the innermost nanotube, referenced 17. In Figure 27C, the region 4 bounds m of the n outermost nanotubes whereas the remaining inner n-m nanotubes contain no such region 4.

In the examples of Figures 27D, E and F, the region 4 extends as a continuous region through all or some of the n nanotubes. In Figure 27D, the region 4 extends through all of the n nanotubes. In Figure 27E, the region 4 extends as a continuous region through all of the nanotubes apart from innermost tube 17. In Figure 27F, the region 4 extends continuously through the n outermost nanotubes but not the remainder.

It will be understood that the various configurations shown in Figure 27 can be achieved by appropriately adjusting the process conditions described with reference to Figure 26. The nanotube structures 1 shown in Figure 27 have different conductivities and generally speaking, the greater the degree of penetration of region 4, the lower the source/drain conductivity of the device.

The modified region 4 can be formed by other methods than the use of a furnace. For example, local heating generated from a focussed electron beam of a conducting tip, such as the tip of an atomic force microscope or an electron beam lithographic system, can be used to induce solid-solid diffusion or a vapour-solid reaction in order to produce a band-modified region 4 locally in the nanotube structure 1. It is also possible that a voltage biased conducting cantilever tip comprising a resistive apex or a focussed ion beam may also be used as a band modification method.

### Flash Memory Cell Array

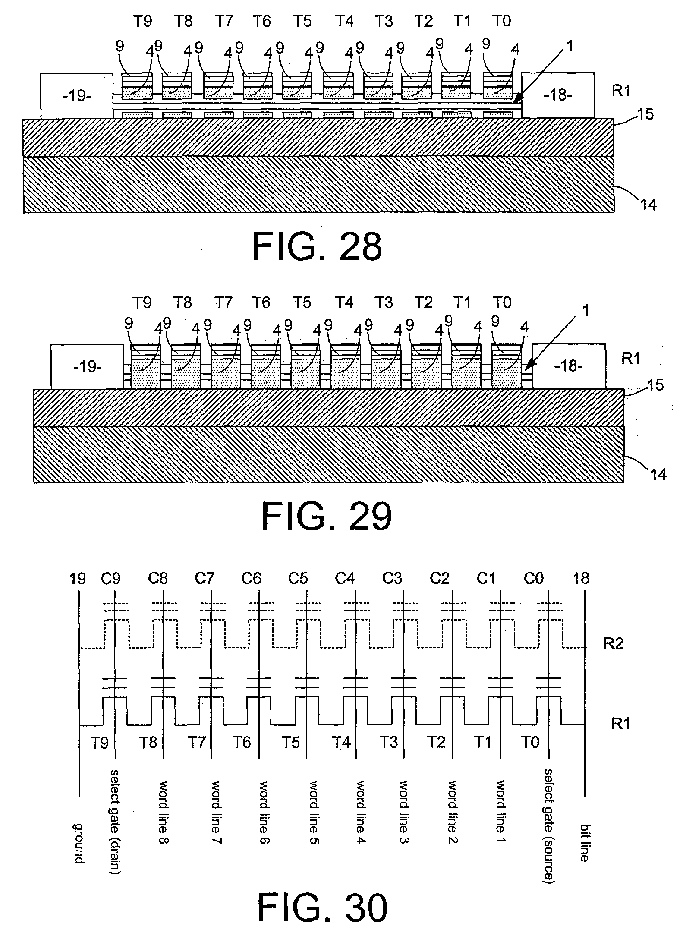

An example of a row of a flash memory cell array incorporating transistors according to the invention will now be described. Figure 28 illustrates a cross-sectional view of a row R1 of the array using A type transistors for the memory cell elements. Figure 29 illustrates a corresponding sectional view of the row R1 when using transistor type B. Figure 30 is a schematic illustration of the circuit diagram of the row R1 of the array with a second row R2 being shown in dotted outline.

Each row of the array comprises the previously described nanotube core structure 1 formed on a silicon dioxide layer 15 on silicon substrate 14. The nanotube core structure 1 is elongated as compared with the previously described device, for example of the order of a few tens of micrometers and extends between bit line 18 and ground line 19 which are formed by conventional metalisation techniques. The core structure 1 has a plurality of spaced apart modified regions 4 with associated electrodes 9, formed as previously described so as to form a series of transistors T0 - T9 each with a source/drain path formed by the nanotube core structure 1, with the source/drain paths being connected in series between the bit and ground lines 18, 19. The gate electrodes 9 for the transistors are connected to individual column conductors C0 - C9 shown in Figure 30, which are connected to the gate electrodes 9 of corresponding transistors in each row. Considering row R1, transistors T1 - T8 act as memory cell elements whereas transistors T0 and T9 act as row selection gates to connect the source/drain paths of the transistors to the bit and ground lines 18, 19. Thus, column electrodes C0 and C9 act as selection lines whereas column electrodes C1 - C8 act as word lines for the array.

In operation, data is stored in an individual element of the array by switching the transistor between its "0" and "1" states as previously described. Data can be read from the elements individually and erased therefrom. This will now be described in more detail.

In order to erase data e.g. from transistor T5, 0V is applied to word line C5 and the other transistors of row R1 are switched on by applying suitable voltages to the column electrodes C0 - C4, C6 - C9. A relatively high erase voltage is applied to the bit line 18 so that a relatively high source/drain voltage is applied to transistor T5 causing any stored electrons on its floating gate to be removed and thereby set the transistor into the "0" state. The other transistors of the row R1 do not, however, have stored data on their floating gates erased by this process.

In order to program data, charge is selectively transferred to the floating gate of the transistor T5. This is achieved by applying a relatively high V_{gw} programming voltage to the fifth word line C5, with the remainder of the transistors switched on using gate voltages < V_{gw}. Then, either a relatively high "1" voltage is applied to bit line 18 or, 0V. When a "1" is stored, electrons tunnel onto the floating gate of transistor T5 as a result of the relatively high voltage on bit line 18 but otherwise, no tunnelling occurs and a "0" state is stored by the transistor.

In order to read data from the individual transistor T5, the bit line 18 is precharged and the row R1 is selected by switching on select gates T0 and T9. This is performed by applying gate voltages to column electrodes C0 and C9. All of the transistors C1 - C4, C6 - C8 are switched on by applying a suitable voltage to column C0 - C4 and C6 - C8. Also, a read voltage is applied to the word line C5. The read voltage is selected to be between the threshold voltages at which the transistor switches on for the "0" and "1" states i.e. between V_{gT0} and V_{gT1}. In the event that transistor T5 stores a "0" state, it will switch on and discharge the bit line 18. However, if the transistor T5 stores an "1" state, the transistor will not switch on and the bit line will remain charged. Thus, the voltage on the bit line 18 is indicative of the stored data during the reading process and can be used as a data output in peripheral circuits (not shown). Thus, the row R1 shown in Figure 29 can store one byte of data and it will be understood that the array may include multiple rows Rn by arranging a plurality of core structures 1 in a generally parallel configuration of the substrate 14.

Many modifications and variations fall within the scope of the invention. For example whilst the invention is described in relation to carbon nanotubes, other conductive nanotubes may be used.

## Claims

1. A transistor device comprising source (S) and drain (D) regions, a nanotube structure (1) providing a path for electrical charge carriers between the source and drain regions, and a gate region (4,9), the nanotube structure having its conduction band structure locally modified in the gate region for controlling the passage of the charge carriers in the path.

2. A transistor device as claimed in claim 1 wherein the gate region comprises a locally doped region (4) of the nanotube structure.

3. A transistor device as claimed in claim 2 wherein the nanotube structure comprises first and second nanotubes (2, 3), one within the other.

4. A transistor device as claimed in claim 3 wherein the locally doped region extends into one of the nanotubes but not the other.

5. A transistor device as claimed in claim 3 wherein the locally doped region extends into both of the nanotubes.

6. A transistor device according to any one of claims 2 to 5 wherein the doped region comprises a semiconductor providing a conduction band barrier that can be controlled by an external voltage applied to the gate region, whereby to control conduction along the path between the source and drain.

7. A transistor device as claimed in any one of claims 2 to 5 wherein the doped region comprises a conductor that forms a Schotkky junction in the nanotube structure that can be controlled by an external voltage applied to the gate region, whereby to control conduction along the path between the source and drain.

8. A transistor device as claimed in any preceding claim wherein the gate region acts a region for electrons and holes to combine and emit photons.

9. A transistor device as claimed in any preceding claim wherein the nanotube structure is formed of carbon.

10. A transistor device as claimed in claim 10 wherein the gate includes a carbide-containing region in the nanotube structure.

11. A transistor device as claimed in claim 11 wherein the carbide containing region includes silicon carbide or a metallic carbide.

12. A transistor device as claimed in any preceding claim and operable as a flash memory.

13. A transistor device as claimed in any preceding claim including a plurality of said gate regions formed along the nanotube structure.

14. A transistor device as claimed in any preceding claim wherein the nanotube structure is disposed on an electrically insulating substrate.

15. A method of fabricating a transistor comprising providing source and drain regions, providing a nanotube structure between the source and drain regions, and modifying the conduction band structure of the nanotube structure locally in a gate region for controlling the passage of the charge carriers through the nanotube structure between the source and drain, and providing a gate connection to the gate region.
